# EUROPEAN PATENT SPECIFICATION

(11) **EP 4 250 372 B1**
(45) Date of publication and mention of the grant of the patent: **09.12.2026**
(21) Application number: 22164469.3
(22) Date of filing: 25.03.2022
(51) Int. Cl.: H10F 77/169, H10F 10/161, H10F 10/162, H10F 10/167, H10F 71/00, H10F 77/12, H10F 77/20, H10F 77/30

(54) **MATERIAL STRUCTURE FOR A SOLAR CELL, A SOLAR CELL COMPRISING THE SAME AND A METHOD FOR MANUFACTURING THE MATERIAL STRUCTURE**
MATERIALSTRUKTUR FÜR EINE SOLARZELLE, DIESE ENTHALTENDE SOLARZELLE UND VERFAHREN ZUM HERSTELLEN DER MATERIALSTRUKTUR
STRUCTURE DE MATÉRIAU POUR UNE CELLULE SOLAIRE, CELLULE SOLAIRE LE COMPRENANT ET PROCÉDÉ DE FABRICATION DE LA STRUCTURE DE MATÉRIAU

(43) Date of publication of application: 27.09.2023
(73) Proprietor: INL - International Iberian Nanotechnology Laboratory, 4715-330 Braga (PT)
(72) Inventor: Sadewasser, Sascha, 4715-330 Braga (PT)
(74) Representative: Couto, Cláudia

(56) References cited:
- WO-A1-2016/162401
- CN-A- 104 143 587
- US-A1- 2014 373 917
- US-A1- 2016 126 401

## Description

### Technical Field

The present invention relates to a material structure for a solar cell. Solar cells comprising the material structure are also disclosed as well as a method for manufacturing the material structure.

### Background Art

Solar cells convert solar energy into electrical energy. Cost-effective large-scale production of solar cells for efficient energy conversion is, however, challenging. A conventional solar cell comprises a light absorbing layer arranged to absorb photons and to convert the energy of the photons into free charge carriers which are separated such that a potential difference is achieved. The light absorbing layer typically forms part of a pn-junction of the solar cell. Hence, radiation of an appropriate wavelength falling on to the light absorbing layer may reach the pn-junction providing electron-hole pairs.

A potential difference over the pn-junction is further obtained as holes and electrons move across the junction in opposite directions. An electric current may thereby be generated which may, e.g., deliver electrical power to an external circuit.

A large cost when manufacturing a solar cell is the expensive materials used. To date, the market is dominated by solar cells based on crystalline silicon wafers onto which a light absorbing layer or layers comprising monocrystalline or multi-crystalline silicon is/are arranged. These solar cells have high conversion efficiencies but are expensive to manufacture and are brittle.

There are, however, other semiconductor materials that have advantageous photovoltaic characteristics. Compounds such as Cu(In,Ga)Se₂, also referred to as CIGS, and CdTe may also be commercially used as light absorbing layers in solar cells. These compounds have higher absorption coefficients as compared to silicon. Therefore, a lower thickness of the light absorbing layer is needed to collect the same number of photons as compared to silicon based solar cells. Thinner and thereby more cost-effective solar cells may hence be provided.

To access the electrical power generated by solar cells, electrodes are formed on the solar cells to extract charge carries from the pn-junction. In some applications such electrodes are formed by a transparent conductive oxide in order to provide a transparent conductive electrode. One such application is a bi-facial solar cell allowing light to enter the solar cell from two sides thereof. Another, such application is a tandem solar cell. For a tandem solar cell, a top cell is required to be transparent to at least a part of the sun's spectrum.

In both bi-facial solar cells and in tandem solar cells, the thickness of the light absorbing layer, e.g., a CIGS layer, needs to be adjusted to a lower thickness to ensure proper current collection and/or current matching. The relatively thin light absorbing layer may lead to contact recombination in the interface between the light absorbing layer and the transparent conductive electrode.

Moreover, typical transparent conductive electrodes consisting of transparent conductive oxides. During deposition of the material of the light absorbing layer, e.g., CIGS, detrimental Ga-oxides tend to be formed from the oxygen of the transparent conductive oxides and Ga from the light absorbing layer. This is further discussed in by Nakada T. Microstructural and diffusion properties of CIGS thin film solar cells fabricated using transparent conducting oxide back contacts, Thin Solid Films. 2005;48:419-425; Heinemann MD, Efimova V, Klenk R, et al. Cu(In,Ga)Se2 superstrate solar cells: prospects and limitations. Prog Photovolt Res Appl. 2015, 23(10):1228-1237; and Terheggen M, Heinrich H, Kostorz G, Haug FJ, Zogg H, Tiwari AN. Ga2O3 segregation in Cu(In, Ga)Se2/ZnO superstrate solar cells and its impact on their photovoltaic properties, Thin Solid Films. 2002, 403-404:212-215.

Document US 2014/373917 A1 discloses a CIGS or a CdTe light absorbing layer with a transparent bottom contact layer electrically connected to it through a passivation layer.

The contact recombination in the interface between the light absorbing layer and the transparent conductive electrode and the detrimental Ga-oxides impact on the effectiveness of the sollar cell. Hence, there is a need to increase the efficiency of the solar cells. This, e.g., in order to lower the cost per watt produced.

### Summary of the invention

It is an object of the present invention to provide an improvement in efficiency of solar cells having a light absorbing layer made from a compound semiconductor material and especially a bifacial or tandem solar cell.

According to a first aspect a material structure for a solar cell is provided according to claim 1.

The material structure comprising: a light absorbing layer comprising a compound semiconductor material; a transparent bottom contact layer comprising a transparent conductive oxide; and a passivation layer arranged in between the light absorbing layer and the contact layer. The passivation layer comprising a plurality of electrical contacts, the electrical contacts extending from a top surface to a bottom surface of the passivation layer such that the electrical contacts are in galvanic contact with the light absorbing layer and the contact layer.

The wording *passivation layer* should be construed as a layer arranged on at least a portion of the transparent bottom contact layer. The passivation layer acts as a spacer layer between the light absorbing layer and the transparent bottom contact layer. Hence, the passivation layer may alleviate that charge carriers, generated by light absorption in the light absorbing layer, are captured by the transparent bottom contact layer. The passivation layer may thereby reduce electron and/or hole recombination at the interface between the transparent bottom contact layer 104 and the light absorbing layer. Accordingly, the passivation layer may increase the efficiency of the material structure. This since it may reduce losses due to contact recombination in the interface between the light absorbing layer and the transparent bottom contact layer. An improved electrical gradient across the light absorbing layer may thereby be achieved resulting in that a higher electrical potential is generated. A more efficient conversion of optical energy to electrical energy may thereby be achieved by the material structure.

Moreover, since the passivation layer acts as a spacer layer between the light absorbing layer and the transparent bottom contact layer detrimental Ga-oxides formed from the oxygen of the transparent conductive oxides of the transparent bottom contact layer and Ga from the light absorbing layer may be avoided.

Moreover, the plurality of electrical contacts of the passivation layer provide charge transport from the light absorbing layer to the transparent bottom contact layer. Such charge transport is provided through point contacts governed by the plurality of electric contacts.

The passivation layer may comprise a dielectric material, such as SiO₂, Al₂N₃, Si₃N₄, AlON, TiO₂, HfO₂. The number of charges originating from the light absorbing layer that are lost due to recombination at the interface between the passivation layer and the light absorbing layer may thereby be reduced. The material structure may thereby reduce recombination losses resulting in an increased electrical performance. By selecting a specific dielectric material, the passivation layer may further be tuned to reflect light within a desired energy range.

The passivation layer may comprise a semiconductor material such as ZnO, InS, In₂O₃, BeO, AIN, BN, GaP.

The passivation layer may have a thickness of 10-50nm.

The transparent conductive oxide may be selected from the group of materials consisting of: ZnO, ITO, FTO, In₂O₃.

The compound semiconductor material may comprise one or more of: Cu(In, Ga)Se2; Cu(In, Ga)(S, Se)2, Cu2ZnSn(S, Se)4, and CdTe. These semiconductor materials are advantageous to use as efficient absorption of light may be achieved within the light absorbing layer when using these materials. Materials comprising Cu, In and Se may form a thin layer that provides high absorption of light to be absorbed in a micron or few microns of the materials. Ga further increases the spectral window for light absorption. The absorption energies of the light absorbing layer may match the solar spectrum. An improved efficiency for absorbing light is thereby obtained.

The electrical contacts comprises a metal. The electrical contacts may thereby provide efficient transfer of charges between the light absorbing layer and the transparent bottom contact layer.

The electrical contacts may comprise molybdenum, Mo. The use of Mo is beneficial as Mo offers low resistivity, good adhesion, has low surface roughness, and is essentially chemically inert to materials such as e.g. Cu, In, Ga, Zn, Sn, S and Se which may form parts of the light absorbing layer. Mo furthermore forms an ohmic contact with the light-absorbing layer and has a low diffusion coefficient. Mo is also stable during elevated temperatures which may for instance occur during the manufacturing of the material structure.

The electrical contacts may have a diameter in the range of 90-400 nm. Spacings between electrical contacts may be in the range of 1 and 10 µm. Hence, although the passivation layer comprises the plurality of electrical contacts, they will only occupy 1-10% of the total surface area of the passivation layer. Accordingly, the passivation layer can be made transparent in 90-99% of its total surface area.

By the use of Mo for the electrical contacts and a compound semiconductor material comprising Se, e.g., CIGS material Mo/MoSe2 contact, as in a regular CIGS device structure is provided. Since 90-99% of the interface area is passivated and without the electrical contacts, transparency is ensured. Using the passivation layer will prevent the Ga-oxide formation.

The material structure may further comprise a buffer layer. The buffer layer may be arranged on the light absorbing layer. The buffer layer and the light absorbing layer may form parts of a pn-junction arranged to convert light to an electric voltage. Efficient separation of charge carriers generated by the light absorbed by the material structure may thereby be obtained.

The material structure may further comprise a top contact. The top contact comprising a transparent conducting layer, the transparent conducting layer being arranged above the buffer layer.

According to a second aspect of the invention a solar cell comprising the material structure of the first aspect is provided. A solar cell with improved efficiency may thereby be obtained. Such a solar cell may, e.g., be a bi-facial solar cell or a multi-junction solar cell. Advantages of using the above disclosed material structure will for brevity not be disclosed again. The above-mentioned features and effects of the material structure for a solar cell, when applicable apply to the solar cell as well.

According to a third aspect a method for manufacturing the material structure for a solar cell according to the first aspect is provided in claim 13. The method comprising the steps of: depositing a transparent bottom contact layer on a substrate, depositing a passivation layer on the transparent bottom contact layer; depositing an imprint polymer on the passivation layer; imprinting the imprint polymer by means of nano-imprint lithography using a template, thereby forming openings in the imprint polymer extending from a top surface to a bottom surface thereof; etching the passivation layer using the imprinted imprint polymer as an etch mask thereby forming openings in the passivation layer extending from a top surface to a bottom surface thereof; forming electrical contacts in the openings in the passivation layer, the electrical contacts being in galvanic contact with the metal layer; and removing the imprinted imprint polymer thereby exposing at least a portion of the passivation layer.

The method may further comprise depositing a buffer layer on the light absorbing layer and forming a top contact comprising a transparent conducting layer on the buffer layer.

The above-mentioned features and effects of the material structure of the first aspect, when applicable, apply to this third aspect as well. In order to avoid undue repetition, reference is made to the above.

Further features of, and advantages with, the present invention will become apparent when studying the appended claims and the following description. The skilled person will realize that different features of the present invention may be combined to create embodiments other than those described in the following, without departing from the scope of the present invention.

### Brief description of the drawings

This and other aspects of the present invention will now be described in more detail, with reference to the enclosed drawings showing embodiments of the invention.
Figure 1 illustrates a material structure for a solar cell.
Figure 2 illustrates a method for manufacturing the material structure.
Figure 3 illustrates pre-stages of the material structure.
Figure 4 illustrates pre-stages of the material structure.
Figure 5 illustrates pre-stages of the material structure.
Figure 6 illustrates a solar cell structure comprising the material structure.

### Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein. These embodiments are rather provided for thoroughness and completeness, and for fully conveying the scope of the invention to the skilled person.

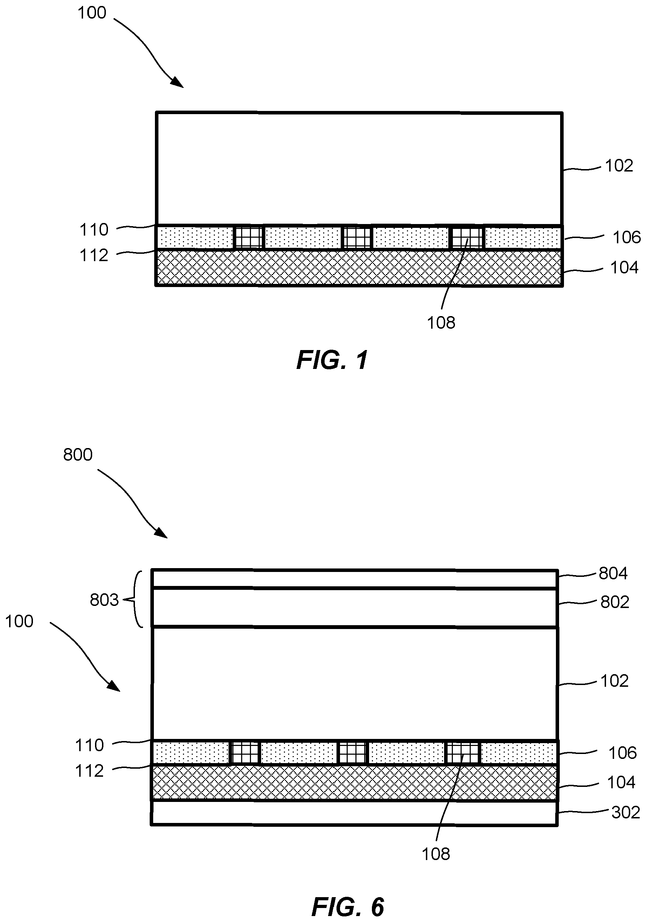

In the following a material structure 100 for a solar cell will be discussed with reference to Fig. 1. Below the terms top and bottom will be used. It to be understood that the use of top and bottom is not limiting material structure 100 to be oriented in a specific manner in space. Instead, the wording top and bottom are only to be indicating relative orientation of the different layers and/or portions of the layer(s) relative each other.

The material structure 100 comprises a light absorbing layer 102, a transparent bottom contact layer 104 and a passivation layer 106. The passivation layer 106 is arranged in between the light absorbing layer 102 and the transparent bottom contact layer 104. A plurality of electrical contacts 108 are arranged within the passivation layer 106. The electrical contacts 108 extend from a top surface 110 to a bottom surface 112 of the passivation layer 106. The electrical contacts 108 are thereby in galvanic contact with the light absorbing layer 102 and the transparent bottom contact layer 104 allowing electrical currents to flow between the light absorbing layer 102 and the transparent bottom contact layer 104.

The light absorbing layer 102 comprises a compound semiconductor material. For example, the light absorbing layer 102 may comprise Cu(In, Ga)Se₂, also referred to as CIGS. The CIGS light absorbing layer 102 has a higher absorption coefficient than silicon and therefore a lower thickness of the light absorbing layer 102 is needed to collect the same number of photons as compared to silicon based solar cells. Alternative compound semiconductor materials to be used for the light absorbing layer 102 are Cu(In, Ga)(S, Se)₂, Cu₂ZnSn(S, Se)₄, or CdTe. A typical thickness of the compound semiconductor material of the light absorbing layer 102 is in the range of 1.5 to 3 µm.

The transparent bottom contact layer 104 consists of a transparent conductive oxide. The transparent bottom contact layer 104 constitutes as transparent conductive electrode for the solar cell within which the material structure 100 is arranged. The transparent conductive oxide may be selected from the group comprising: Zink Oxide (ZnO), Indium doped Tin Oxide (ITO), Fluorine doped Tin Oxide (FTO), TitaniumdiOxide (TiO2) and Hydrogen doped Indium Oxide (IOH). The Zink Oxide may be doped, e.g., with Al, Ga or In. A thickness of the light absorbing layer 102 depends on the conductivity that can be achieved with the material chosen, but typically the thickness of the light absorbing layer 102 is in the range of 100 to 1000 nm.

The electrical contacts 108 may have a diameter in the range of 90-400 nm. Further, spacings between electrical contacts 108 may be in the range of 1 to 10 µm. Hence, although the passivation layer 106 comprises the plurality of electrical contacts 108 they will only occupy 1-10% of the total surface area of the passivation layer 106.

The electrical contacts 108 comprises a metal. The electrical contacts 108 may thereby provide efficient transfer of charges between the light absorbing layer 102 and the transparent bottom contact layer 104. The electrical contacts 108 may comprise molybdenum, Mo. Electrical contacts 108 made of Mo offer low resistivity and good adhesion to the light absorbing layer 102. Mo is moreover essentially chemically inert to the materials Cu, In, Ga, and Se of the compound semiconductor material, even at elevated temperatures such as a CIGS high-temperature selenization process at which the temperature may be above 500°C. It may be noted that at such temperatures a thin MoSe₂ layer may be formed on the Mo electrical contacts 108 which further improves the conducting properties of the electrical contacts 108. Mo furthermore allows for the formation of ohmic contacts to the light-absorbing layer 102. Mo also has a low diffusion coefficient which makes the material stable even at elevated temperatures. Elevated temperatures may for instance occur during the manufacturing of the material structure 100. The performance of the material structure 100 may thereby be improved.

The passivation layer 106 may have a thickness of 10-50nm. For these thicknesses, there is sufficient fixed charges in the passivation layer 106 to lead to a field-effect passivation, repelling of electrons back into the light-absorbing layer 102. On the other hand, the aspect ratio of 90-400 nm wide holes for accommodating the electrical contacts 108 in passivation layer 106 is sufficiently low to allow relatively easy fabrication by resists and reactive ion etching.

The passivation layer 106 may comprise a dielectric material. A dielectric material typically has fixed charges, which lead to field-effect passivation by repelling charge carriers. In the present disclosure fixed negative charges repelling the electrons away from the back contact and thereby contributing to avoid recombination. This passivation effect is complemented by passivating electronic interface defects. One example of a dielectric material is Al₂O₃. The use of Al₂O₃ allows for an insulating passivation layer 106 having a large concentration of fixed charges, which may be deposited conformally on top of the transparent bottom contact layer 104. Alternative dielectric materials for the passivation layer are SiO₂, Al₂N₃, Si₃N₄, AlON, TiO₂, HfO₂.

Alternatively, the passivation layer 106 may comprise a semiconductor material such as ZnO, InS, In₂O₃, BeO, AIN, BN, GaP. These semiconductors are all wide bandgap materials. If deposited correctly, they are nonconductive and serve as an insulator.

The passivation layer 106 acts as a spacer layer between the light absorbing layer 102 and the transparent bottom contact layer 104. Hence, the passivation layer 106 may alleviate that charge carriers, generated by light absorption in the light absorbing layer 102, are captured by the transparent bottom contact layer 104. The passivation layer may thereby reduce electron and/or hole recombination at the interface between the transparent bottom contact layer 104 and the light absorbing layer 102. Accordingly, the passivation layer 106 may increase the efficiency of the material structure 100. This since it may reduce losses due to contact recombination in the interface between the light absorbing layer 102 and the transparent bottom contact layer 104. An improved electrical gradient across the light absorbing layer 102 may thereby be achieved resulting in that a higher electrical potential is generated. A more efficient conversion of optical energy to electrical energy may thereby be achieved by the material structure 100.

Moreover, since the passivation layer 106 acts as a spacer layer between the light absorbing layer 102 and the transparent bottom contact layer 104 detrimental oxides formed from the oxygen of the transparent conductive oxides of the transparent bottom contact layer 104 and elements from the light absorbing layer 102 may be avoided. For example, formation of Ga oxides, In oxides, Cu oxides, Zn oxides, Sn oxides or Selenium oxides may be avoided.

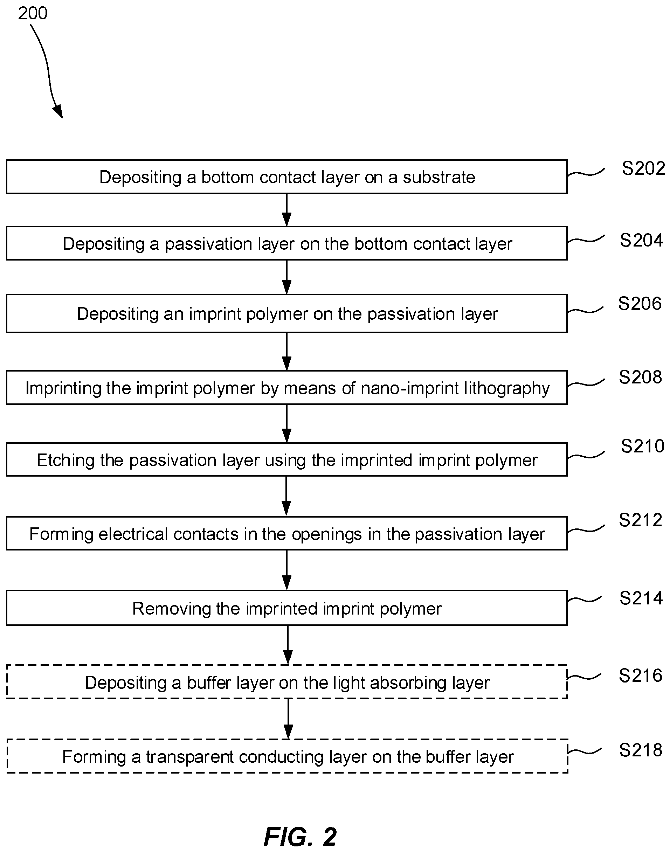

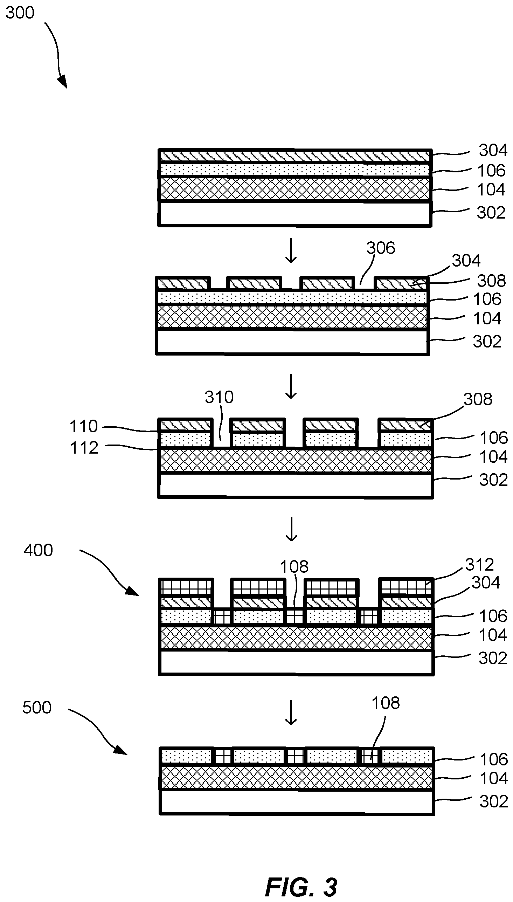

Next a method 200 for manufacturing the material structure 100 will be described with reference to figures 2 and 3. Figure 2 illustrates method steps whereas figure 3 illustrates pre-stages 300 of the material structure and material structure 100 achieved by performing the method 200.

The method 200 comprises depositing S202 the transparent bottom contact layer 104 on a substrate 302. The depositing S202 may, e.g., be made by magnetron sputtering, pulsed laser deposition, atomic layer deposition, and/or chemical vapor deposition. As discussed above, the transparent bottom contact layer 104 comprises a transparent conductive oxide. The substrate 302 may comprises soda-lime glass, but the skilled person realizes that other substrates may be used as will be described below. Soda lime glass contains sodium, which has been shown to yield a substantial open-circuit voltage increase through surface and/or grain boundary defects passivation. The substrate may have a thickness of 1-3 mm. Actually, in the case of use of a flexible substrate the thickness could be as low as 10 micrometer.

The dielectric or semiconducting material of the passivation layer 106 is thereafter deposited S204 on the transparent bottom contact layer 104, followed by deposition S206 of an imprint polymer 304 on the passivation layer 106. The deposition S204 may be performed by atomic layer deposition, ALD. The deposition S206 may be performed by standard techniques such as spin-coating also referred to as spin-casting. The imprint polymer 304 may comprise polymethyl methacrylate, PMMA. PMMA has a small and advantageous thermal expansion coefficient and a small pressure shrinkage coefficient. Template release agents may further be added into the imprint polymer to reduce adhesion to the template. Also, to template may be antisticking treated to facilitate its removal from the imprint polymer. The skilled person in the art realizes that UV-curable imprint polymers may be used when fabricating the material structure. In this case an irreversible cross-linked imprint polymer is used.

Nano-imprint lithography, NIL, is used to form a pattern in the passivation layer 106. In NIL the imprint polymer 304 is imprinted S208 using a template, also referred to as mold or stamp. The template comprises patterns, for example nanostructured patterns, which are transferred to the imprint polymer 304 when the template is pressed into the imprint polymer 304. In other words, the pressing of the template into the imprint polymer 304 creates an inverse pattern of the template resulting in that the imprint polymer 304 has a varying thickness. The template may for example comprise silicon dioxide or silicon. Other materials such as metals and ceramics may also be used for the template. The template may for instance be patterned using electron beam lithography and reactive ion etching, RIE. The template is removed after the imprint polymer has been imprinted, i.e., after the pattern of the template has been transferred into the imprint polymer 304. An anisotropic etching process, such as reactive ion etching, RIE, may further be used to remove residuals of the imprint polymer 304 in the area forming openings, i.e., the compressed area. During the imprinting S208, the imprint polymer 304 may be heated to a temperature above its glass transition temperature. The imprint polymer 304 may be a thermoplastic or thermosetting polymer which becomes a viscous liquid which can flow when heated, and therefore, be readily deformed when imprinted with the template. Generally, the imprint polymer 304 is cooled such that the imprint polymer 304 solidifies before the template is removed. A more effective transfer of the pattern of the template into the imprinted imprint polymer 304 may thereby be obtained. Openings 306 in the imprint polymer 304 are thereby formed by the imprinting S208.

It should be noted that the resolution of NIL, unlike conventional lithography methods such as electron beam lithography and optical lithography using energetic beams, is not limited by the effects of wave diffraction, scattering and interference in a resist, i.e., the imprint polymer, and backscattering from the substrate. An improved resolution for manufacturing features on the nanoscale may thereby be obtained. Beam scanning is moreover not needed in NIL which improves the speed for manufacturing the material structure. Hence, NIL offers high-resolution high-throughput lithography which may be used for low-cost mass production of nanostructures over large areas.

Next, the dielectric or semiconducting material of the passivation layer 106 is etched S210 using the imprinted imprint polymer 304 as an etch mask 308 such that openings 310 are formed in the dielectric or semiconducting material of the passivation layer 106. The openings 310 extend from the top surface 110 to the bottom surface 112 of the passivation layer 106. The etching S210 may be performed using reactive ion etching.

After the openings 310 in the passivation layer 106 have been formed, electrical contacts 108 may be formed S212 in the openings 310. The electrical contacts 108 may be formed by different processes as will be described below. The electrical contacts 108 should, however, be in galvanic contact with the transparent bottom contact layer 104.

The imprinted imprint polymer 304 may then be removed S214. Thereby at least a portion of the passivation layer 106 will be exposed. The imprinted imprint polymer 304 may be removed by a standard heated polymer "remover". Typically, an ultrasonic bath is used during the removal together with an organic element such as acetone or a commercially available polymer remover. Techniques such as O₂-plasma treatment may further be used for the removing S214.

According to one example, the electrical contacts 108 may be formed S212 using sputtering and/or evaporation of a metal as illustrated by the pre-stage 400 of the material structure shown in figure 3. Methods for depositing materials such as metals are known in the field of the art and will not be discussed further. Sputtering and/or evaporation of the metal, before the imprinted imprint polymer 304 is removed S214, results in that metal 312 may be deposited on at least a portion of the imprinted imprint polymer 304. The electrical contacts 108 extend preferably through the passivation layer 106.

The removing S214 of the imprinted imprint polymer may be performed using a lift-off process. The lift-off of the imprinted polymer layer may be performed by soaking the substrate in acetone or a remover in an ultrasonic bath. The imprinted imprint polymer 106 and the metal 312 may thereby be efficiently removed by the lift-off. The resulting pre-stage 500 of the material structure is shown in figure 3. Methods and recipes for lift-off is known to a skilled person in the art and reference may for example be given to Carlberg et al, "Lift off process for nanoimprint lithography", Microelectronic Engineering 67-68, p 203 (2003).

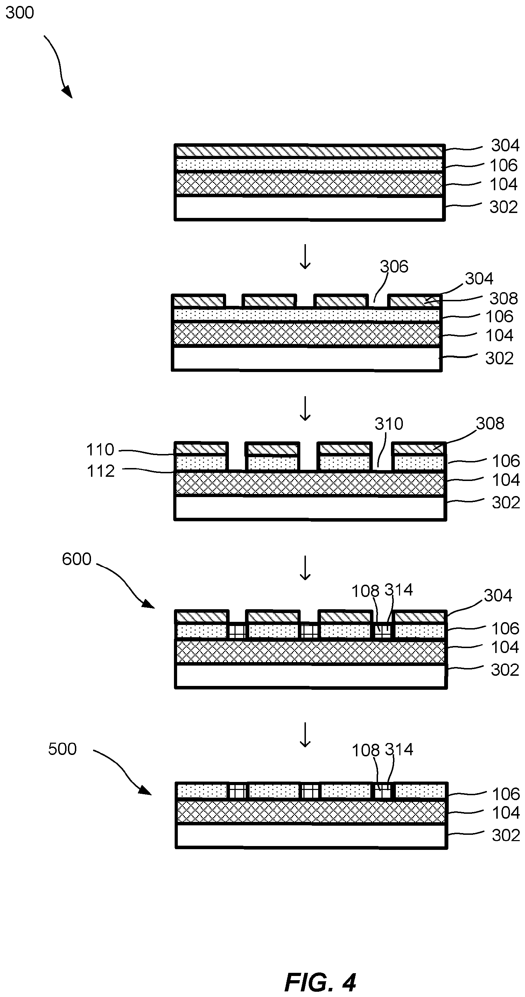

Now referring to figure 4, the forming S212 of the electrical contacts 108 may alternatively comprise selective deposition of a metal 314. The metal 314 may thereby be formed essentially only in the openings 310 of the passivation layer 106, as illustrated by the pre-stage 600 of the material structure. The selective deposition of a metal 314 may be achieved by electroplating. Electroplating is a well-known technique within the field of nano-processing which may take advantage of the imprint polymer 106 being an insulator such that the metal is deposited primarily on surfaces of the metal layer 104 that are exposed in the openings 310. The electrical contacts 108 extend through the passivation layer 106. The imprinted imprint polymer 304 may then be removed S214 as described above, thereby exposing at least a portion of the passivation layer 106.

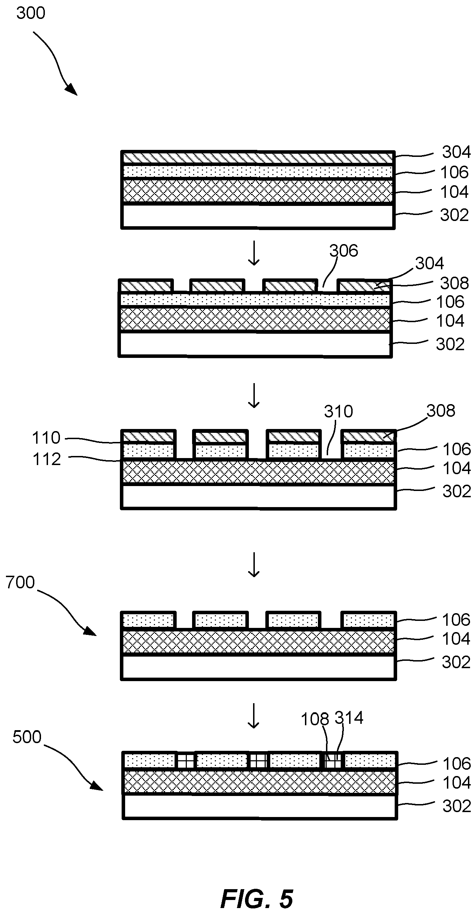

Now referring to figure 5, the removing S214 of the imprinted imprint polymer 106 may alternatively be performed prior to the step of forming S212 of the electrical contacts 108, which results in that the pre-stage 700 of the material structure is obtained. The electrical contacts 108 may thereafter be formed S212 as described above by selective deposition such that the pre-stage 500 of the material structure is formed.

The method 200 may further comprise depositing S216 a buffer layer 802 on the light absorbing layer 102. This is illustrated in figure 6. The buffer layer 802 may be deposited S216 using a standard chemical bath deposition, CBD, process. A thickness of the buffer layer 802 may be in the range of 10-50 nm. Such thin buffer layer 802 is desired to avoid parasitic absorption of light. On the other hand, if the buffer layer 802 is too thin, it might not provide required band alignment. Further, if the buffer layer 802 is too thin, it might not provide required protection of the light absorbing layer 102, Especially not during subsequent sputter deposition of a top transparent conducting layer 804, discussed in more detail below. According to one example, the light absorbing layer 102 is composed of CIGS which is p-type and the buffer layer 802 comprises a CdS material which is n-type. The light absorbing layer 102 and the buffer layer 802 thereby form parts of a pn-junction arranged to convert light to an electric voltage. The buffer layer 802 may further form part of a stack of layers 803 as illustrated in figure 6. The stack of layers 803 may comprise a transparent conducting layer 804 arranged on top of the buffer layer 802. The transparent conducting layer 804 is a top contact for a solar cell structure 800. The transparent conducting layer 804 may be formed S218 using shunt reducing intrinsic ZnO layer, i-ZnO, and subsequently sputtering of Al-doped ZnO, ZnO:Al.

The solar cell structure 800 may be a bi-facial solar cell 800. Alternatively, the solar cell structure 800 may form a part of a Multi-junction solar cell, e.g., a top cell of a tandem solar cell.

The transparent conducting layer 804 may comprise a i-ZnO/ZnO:Al material, i.e., a thin (20-100 nm), intrinsic zinc oxide layer (i-ZnO) which is capped by a thicker (100-500 nm), aluminum, Al, doped ZnO layer. The i-ZnO layer is used to protect the buffer layer 802 and the light absorbing layer 102 from sputtering damage while depositing the ZnO:Al layer. The Al doped ZnO serves as a transparent conducting oxide to collect and move electrons out of the solar cell structure 800 while absorbing as little light as possible.

The solar cell structure 800 comprises a heterostructure junction formed between the light absorbing layer 102 and the transparent conducting layer 804, which are separated by the buffer layer 802. The light absorbing layer 102 may be doped p-type by intrinsic defects, while the transparent conducting layer 804 may be doped n-type to a much larger extent through, e.g., incorporation of Al. This asymmetric doping provides a space-charge region extend to a larger extent into the light absorbing layer 102 than into the transparent conducting layer 804. The absorption of light and collection of generated charge carriers (electron-hole pairs) is thereby designed to predominately occur in the light absorbing layer 102. To this end, the thicknesses and band gaps of the light absorbing layer 102, the buffer layer 802, and the transparent conducting layer 804 are chosen such that the light is absorbed predominately in the light absorbing layer 102. The band gap of the light absorbing layer 102 ranges typically between 1.02 eV for CuInSe₂ to 1.65 eV for CuGaSe₂ providing increased light absorption, while the larger band gaps for ZnO of 3.2 eV and CdS of 2.4 eV minimizes light absorption in the upper layers 802 and 804. The doped ZnO may also serve as front contact for current collection.

The stack of layers 803 may further comprise anti-reflective coating, not shown, which may be formed by evaporation to improve light absorption of the solar cell, mainly by avoiding interference effects.

A front contact grid comprising a Ni/Al/Ni stack, not shown, may further be deposited by evaporation.

The person skilled in the art further realizes that the present invention by no means is limited to the preferred embodiments described above. On the contrary, many modifications and variations are possible within the scope of the appended claims.

For example, the substrate 302 may be a glass material such as alkali-aluminosilicate glass or boro-silicate glass. The substrate 302 may alternatively comprise a metal foil, a ceramic substrate, or a plastic substrate.

In an embodiment not part of the invention, the light absorbing layer 102 may alternatively be a compound semiconductor material comprising a plurality of other elements from the periodic table. The light absorbing layer may be of a group IV element such as Si, amorphous Si, nanocrystalline silicon or micromorphous silicon.

In an embodiment not part of the invention, the light absorbing layer 102 may comprise a III-V or a II-VI semiconductor material. Hence the light absorbing layer 102 may in some embodiments for example comprise GaAs, and InP. The light absorbing layer 102 may be of a material having a perovskite crystal structure.

In an embodiment not part of the invention, the light absorbing layer 102 may be formed form by a chalcopyrite or a kesterite material. For such materials the substrate 302 may be a sheet of glass or foil. The glass substrate may for example have a dimension of 80 cm x 120 cm. The foil may typically be arranged in a roll of a specific width, which may be 1 m in extension.

The buffer layer 802 may alternatively comprise a material selected from a group consisting of Zn₁₋ₓSnₓO_{y}, In₂S₃, Zn(S,O,OH), Zn(S,O), InSₓO_{y}, ZnS, ZnS:In₂S₃, InₓS_{y}.

The transparent conductive layer 804 may, moreover, comprise a material selected from a group consisting of Ga-doped ZnO, SnO₂:In₂O₃,SnO₂:F, CdO:In, graphene, and carbon nano-tubes.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A material structure for a solar cell, the material structure (100) **characterized by** comprising:
a light absorbing layer (102) comprising a compound semiconductor material comprising one or more of: Cu(In, Ga)Se₂; Cu(In, Ga)(S, Se)₂, Cu₂ZnSn(S, Se)₄, and CdTe;
a transparent bottom contact layer (104) comprising a transparent conductive oxide; and
a passivation layer (106) arranged in between the light absorbing layer (102) and the contact layer (104), the passivation layer (106) comprising a plurality of electrical contacts (108) which comprise a metal, the electrical contacts (108) extending from a top surface (110) to a bottom surface (112) of the passivation layer (106) such that the electrical contacts (108) are in galvanic contact with the light absorbing layer (102) and the contact layer (104).

2. The material structure according to claim 1, wherein the transparent conductive oxide is selected from the group of materials consisting of: ZnO, ITO, FTO, In₂O₃.

3. The material structure according to claim 1 or 2, wherein the passivation layer (106) comprises a dielectric material, such as SiO₂, Al₂N₃, Si₃N₄, AlON, TiO₂, HfO₂.

4. The material structure according to claim 1 or 2, wherein the passivation layer (106) comprises a semiconductor material such as ZnO, InS, In₂O₃, BeO, AIN, BN, GaP.

5. The material structure according to any one of claims 1-4, wherein the passivation layer has a thickness of 10-50nm.

6. The material structure according to any one of claims 1-5, wherein the electrical contacts (108) have a diameter in the range of 90-400 nm.

7. The material structure according to any one of claims 1-6, wherein spacings between electrical contacts (108) are in the range of 1 and 10 µm.

8. The material structure according to any one of claims 1-7, wherein the electrical contacts (108) comprise molybdenum, Mo.

9. The material structure according to any one of claims 1-8, further comprising a buffer layer (802) arranged on the light absorbing layer (102), the buffer layer (802) and the light absorbing layer (102) forming parts of a pn-junction arranged to convert light to an electric voltage.

10. The material structure according to claim 9, further comprising a top contact comprising a transparent conducting layer (804), the transparent conducting layer (804) being arranged above the buffer layer (802).

11. A multi-junction solar cell comprising the material structure of any one of claims 1-10.

12. A bi-facial solar cell comprising the material structure of any one of claims 1-10.

13. A method for manufacturing a material structure (100) for a solar cell according to any one of claims 1-10, the method comprising the steps of:
depositing (S202) a transparent bottom contact layer (104) on a substrate (302);
depositing (S204) a passivation layer (106) on the transparent bottom contact layer (104);
depositing (S206) an imprint polymer (304) on the passivation layer (106),
imprinting (S208) the imprint polymer (304) by means of nano-imprint lithography, NIL, using a template, thereby forming openings (306) in the imprint polymer (304) extending from a top surface to a bottom surface thereof;
etching (S210) the passivation layer (106) using the imprinted imprint polymer (304) as an etch mask thereby forming openings (310) in the passivation layer (106) extending from a top surface (110) to a bottom surface (112) thereof;
forming (S212) electrical contacts (108) which comprise a metal in the openings (310) in the passivation layer (106), the electrical contacts (108) being in galvanic contact with the transparent bottom contact layer (104);
removing (S214) the imprinted imprint polymer (304) thereby exposing at least a portion of the passivation layer (106); and
depositing, on the passivation layer (106), a light absorbing layer (102) comprising a compound semiconductor material comprising one or more of: Cu(In, Ga)Se₂; Cu(In, Ga)(S, Se)₂, Cu₂ZnSn(S, Se)₄, and CdTe.

14. The method according to claim 13, further comprising depositing a buffer layer (802) on the light absorbing layer (102) and forming a top contact comprising a transparent conducting layer (804) on the buffer layer (802).

## Patentansprüche

1. Materialstruktur für eine Solarzelle, wobei die Materialstruktur (100) **dadurch gekennzeichnet ist, dass** sie Folgendes umfasst:
eine lichtabsorbierende Schicht (102), die ein zusammengesetztes Halbleitermaterial umfasst, das eines oder mehrere der folgenden Materialien enthält: Cu(ln, Ga)Se₂; Cu(ln, Ga)(S, Se)₂, Cu₂ZnSn (S, Se)₄, und CdTe;
eine transparente untere Kontaktschicht (104), die ein transparentes leitfähiges Oxid umfasst; und
eine Passivierungsschicht (106), die zwischen der lichtabsorbierenden Schicht (102) und der Kontaktschicht (104) angeordnet ist, wobei die Passivierungsschicht (106) eine Vielzahl von elektrischen Kontakten (108) umfasst, die aus einem Metall bestehen, wobei sich die elektrischen Kontakte (108) von einer Oberseite (110) bis zu einer Oberfläche (112) der Passivierungsschicht (106) erstrecken, sodass die elektrischen Kontakte (108) in galvanischem Kontakt mit der lichtabsorbierenden Schicht (102) und der Kontaktschicht (104) stehen.

2. Materialstruktur nach Anspruch 1, wobei das transparente leitfähige Oxid aus der Gruppe von Materialien ausgewählt ist, bestehend aus: ZnO, ITO, FTO, ln₂O₃.

3. Materialstruktur nach Anspruch 1 oder 2, wobei die Passivierungsschicht (106) ein dielektrisches Material umfasst, wie beispielsweise SiO₂, Al₂N3, Si₃N₄, AlON, TiO₂, HfO₂.

4. Materialstruktur nach Anspruch 1 oder 2, wobei die Passivierungsschicht (106) ein Halbleitermaterial wie beispielsweise ZnO, InS, ln₂O₃, BeO, AlN, BN, GaP umfasst.

5. Materialstruktur nach einem der Ansprüche 1-4, wobei die Passivierungsschicht eine Dicke von 10-50 nm aufweist.

6. Materialstruktur nach einem der Ansprüche 1-5, wobei die elektrischen Kontakte (108) einen Durchmesser im Bereich von 90-400 nm aufweisen.

7. Materialstruktur nach einem der Ansprüche 1-6, wobei die Abstände zwischen den elektrischen Kontakten (108) im Bereich von 1 und 10 µm liegen.

8. Materialstruktur nach einem der Ansprüche 1 bis 7, wobei die elektrischen Kontakte (108) Molybdän, Mo, umfassen.

9. Materialstruktur nach einem der Ansprüche 1 bis 8, die ferner eine auf der lichtabsorbierenden Schicht (102) angeordnete Pufferschicht (802) umfasst, wobei die Pufferschicht (802) und die lichtabsorbierende Schicht (102) Teile eines p-n-Übergang bilden, der so angeordnet ist, dass er Licht in eine elektrische Spannung umwandelt.

10. Materialstruktur nach Anspruch 9, die ferner einen oberen Kontakt umfasst, der eine transparente leitfähige Schicht (804) umfasst, wobei die transparente leitfähige Schicht (804) oberhalb der Pufferschicht (802) angeordnet ist.

11. Mehrfach-Übergangs-Solarzelle, welche die Materialstruktur eines der Ansprüche 1-10 umfasst.

12. Beidseitige Solarzelle, welche die Materialstruktur nach einem der Ansprüche 1 bis 10 aufweist.

13. Verfahren zur Herstellung einer Materialstruktur (100) für eine Solarzelle nach einem der Ansprüche 1 bis 10, wobei das Verfahren die folgenden Schritte umfasst:
Aufbringen (S202) einer transparenten unteren Kontaktschicht (104) auf ein Substrat (302);
Aufbringen (S204) einer Passivierungsschicht (106) auf die transparente untere Kontaktschicht (104);
Aufbringen (S206) eines Prägepolymers (304) auf die Passivierungsschicht (106),
Prägen (S208) des Prägepolymers (304) mittels Nanoprägelithografie (NIL) unter Verwendung einer Schablone, wodurch Öffnungen (306) im Prägepolymer (304) gebildet werden, die sich von dessen Oberseite bis zu dessen Unterseite erstrecken;
Ätzen (S210) der Passivierungsschicht (106) unter Verwendung des geprägten Prägepolymers (304) als Ätzmaske, wodurch Öffnungen (310) in der Passivierungsschicht (106) gebildet werden, die sich von einer Oberseite (110) bis zu einer Unterseite (112) derselben erstrecken;
Bilden (S212) von elektrischen Kontakten (108), die ein Metall umfassen, in den Öffnungen (310) der Passivierungsschicht (106), wobei die elektrischen Kontakte (108) in galvanischem Kontakt mit der transparenten unteren Kontaktschicht (104) stehen;
Entfernen (S214) des eingeprägten Prägepolymers (304), wodurch zumindest ein Teil der Passivierungsschicht (106) freigelegt wird; und
Aufbringen einer lichtabsorbierenden Schicht (102) auf die Passivierungsschicht (106), die ein zusammengesetztes Halbleitermaterial umfasst, das eines oder mehrere der folgenden umfasst: Cu(ln, Ga)Se₂; Cu(ln, Ga)(S, Se)₂, Cu₂ZnSn(S, Se)₄, and CdTe.

14. Verfahren nach Anspruch 13, das ferner das Aufbringen einer Pufferschicht (802) auf die lichtabsorbierende Schicht (102) und das Ausbilden eines oberen Kontakts, der eine transparente leitfähige Schicht (804) umfasst, auf der Pufferschicht (802) umfasst.

## Revendications

1. Structure de matériau pour une cellule solaire, la structure de matériau (100) étant **caractérisée en ce qu'**elle comprend :
une couche absorbant la lumière (102) comprenant un matériau semi-conducteur composé comprenant un ou plusieurs parmi : Cu(In, Ga)Se₂ ; Cu(In, Ga)(S, Se)₂, Cu₂ZnSn(S, Se)₄ et CdTe ;
une couche de contact inférieure transparente (104) comprenant un oxyde conducteur transparent ; et
une couche de passivation (106) agencée entre la couche absorbant la lumière (102) et la couche de contact (104), la couche de passivation (106) comprenant une pluralité de contacts électriques (108) qui comprennent un métal, les contacts électriques (108) s'étendant depuis une surface supérieure (110) jusqu'à une surface inférieure (112) de la couche de passivation (106) de telle sorte que les contacts électriques (108) sont en contact galvanique avec la couche absorbant la lumière (102) et la couche de contact (104).

2. Structure de matériau selon la revendication 1, dans laquelle l'oxyde conducteur transparent est choisi dans le groupe de matériaux constitué de : ZnO, ITO, FTO, In₂O₃.

3. Structure de matériau selon la revendication 1 ou 2, dans laquelle la couche de passivation (106) comprend un matériau diélectrique, tel que SiO₂, Al₂N₃, Si₃N₄, AlON, TiO₂, HfO₂.

4. Structure de matériau selon la revendication 1 ou 2, dans laquelle la couche de passivation (106) comprend un matériau semi-conducteur tel que ZnO, InS, In₂O₃, BeO, AlN, BN, GaP.

5. Structure de matériau selon l'une quelconque des revendications 1 à 4, dans laquelle la couche de passivation a une épaisseur de 10 à 50 nm.

6. Structure de matériau selon l'une quelconque des revendications 1 à 5, dans laquelle les contacts électriques (108) ont un diamètre compris dans la plage de 90 à 400 nm.

7. Structure de matériau selon l'une quelconque des revendications 1 à 6, dans laquelle des espacements entre les contacts électriques (108) sont compris entre 1 et 10 µm.

8. Structure de matériau selon l'une quelconque des revendications 1 à 7, dans laquelle les contacts électriques (108) comprennent du molybdène, Mo.

9. Structure de matériau selon l'une quelconque des revendications 1 à 8, comprenant en outre une couche tampon (802) agencée sur la couche absorbant la lumière (102), la couche tampon (802) et la couche absorbant la lumière (102) formant des parties d'une jonction pn agencée pour convertir la lumière en une tension électrique.

10. Structure de matériau selon la revendication 9, comprenant en outre un contact supérieur comprenant une couche conductrice transparente (804), la couche conductrice transparente (804) étant agencée au-dessus de la couche tampon (802).

11. Cellule solaire multijonction comprenant la structure de matériau selon l'une quelconque des revendications 1 à 10.

12. Cellule solaire bifaciale comprenant la structure de matériau selon l'une quelconque des revendications 1 à 10.

13. Procédé de fabrication d'une structure de matériau (100) pour une cellule solaire selon l'une quelconque des revendications 1 à 10, le procédé comprenant les étapes consistant à :
déposer (S202) une couche de contact inférieure transparente (104) sur un substrat (302) ;
déposer (S204) une couche de passivation (106) sur la couche de contact inférieure transparente (104) ;
déposer (S206) un polymère d'impression (304) sur la couche de passivation (106),
imprimer (S208) le polymère d'impression (304) au moyen d'une lithographie par nano-impression, NIL, en utilisant un moule, formant ainsi dans le polymère d'impression (304) des ouvertures (306) s'étendant depuis une surface supérieure jusqu'à une surface inférieure de celui-ci ;
graver (S210) la couche de passivation (106) en utilisant le polymère d'impression imprimé (304) comme masque de gravure, formant ainsi dans la couche de passivation (106) des ouvertures (310) s'étendant depuis une surface supérieure (110) jusqu'à une surface inférieure (112) de celle-ci ;
former (S212) des contacts électriques (108) qui comprennent un métal dans les ouvertures (310) de la couche de passivation (106), les contacts électriques (108) étant en contact galvanique avec la couche de contact inférieure transparente (104) ;
retirer (S214) le polymère d'impression imprimé (304), mettant ainsi à nu au moins une partie de la couche de passivation (106) ; et
déposer, sur la couche de passivation (106), une couche absorbant la lumière (102) comprenant un matériau semi-conducteur composé comprenant un ou plusieurs parmi : Cu(In, Ga)Se₂ ; Cu(In, Ga)(S, Se)₂, Cu₂ZnSn(S, Se)₄ et CdTe.

14. Procédé selon la revendication 13, comprenant en outre le dépôt d'une couche tampon (802) sur la couche absorbant la lumière (102) et la formation d'un contact supérieur comprenant une couche conductrice transparente (804) sur la couche tampon (802).
